# FASCICULE DE BREVET EUROPEEN

(11) **EP 1 752 803 B1**
(45) Date de publication et mention de la délivrance du brevet: **20.02.2019**
(21) Numéro de dépôt: 06118344.8
(22) Date de dépôt: 02.08.2006
(51) Int. Cl.: G02B 6/12, G02B 6/42

(54) **Dispositif optoélectronique integré**
Integrierte optoelektronische Vorrichtung
Integrated optoelectronic device

(30) Priorité: 05.08.2005 FR 0508386
(43) Date de publication de la demande: 14.02.2007
(73) Titulaire: Provenance Asset Group LLC, Essex, CT 06426 (US)
(72) Inventeur: Achouche, Mohand M., 92120, Montrouge (FR); Brenot, Romain M., 75001, Paris (FR); HARARI, Joseph M., 59990 SEBOURG (FR); MAGNIN, Vincent M., 59700 MARCQ EN BAROEUL (FR)
(74) Mandataire: Abel & Imray

(56) Documents cités:
- WO-A-01/88577
- JOH. M HUTCHINSON ETAL.: "Monolithically integrated InP-based tunable wavelength conversion" PRPCEEDINGS OF THE SPIE, vol. 5349, 2004, pages 176-184, XP002372445
- JOACHIM PIPREK ET AL.: "3D Simulation of an Integrated Wavelength Converter" PHYSICS AND SIMULATION OF OPTOELECTRONIC DEVICES XII, PFROCEEDINGS OF THE SPIE, vol. 5349, 2004, pages 185-196, XP002372446
- CAMPBELL J C ET AL: "New developments in high speed photodetectors" LASERS AND ELECTRO-OPTICS, 2004. (CLEO). CONFERENCE ON SAN FRANCISCO, CA, USA MAY 20-21, 2004, PISCATAWAY, NJ, USA,IEEE, vol. 2, 20 mai 2004 (2004-05-20), pages 251-251, XP010744666 ISBN: 1-55752-777-6
- UMBACH A.: "High-speed integrated photodetectors for 40 Gbit/s applications" PROCEEDINGS OF THE SPIE, SPIE, BELLINGHAM, VA, US, vol. 5246, no. 1, 2003, pages 434-442, XP002333520 ISSN: 0277-786X
- STÉPHANE DEMIGUEL ET AL.: "Analysis of Partially Depleted Absorber Waveguide Photodiodes" JOURNAL OF LIGHTWAVE TECHNOLOGIES, vol. 23, no. 8, 1 août 1005 (1005-08-01), pages 2505-2512, XP002372447
- STEPHANE DEMIGUEL ET AL.: "Very High-Responsivity Evanescently Coupled Photodiodes Integrating a Short Planar Multimode Waveguide for HIgh-Speed Applications" IEEE PHOTONICS TECHNOLOGY LETTERS, vol. 15, no. 12, 1 décembre 2003 (2003-12-01), pages 1761-1763, XP002372448
- JOE C. CAMPBELL ET AL.: "Recent Advances in Avalanche Photodiodes" IEEE JOURNAL OF SELECTED TOPICS IN QUANTUM ELECTRONICS, vol. 10, no. 4, 1 juillet 2004 (2004-07-01), pages 777-787, XP002372449
- DEMIGUEL S ET AL: "High-responsivity and high-speed evanescently-coupled avalanche photodiodes" ELECTRONICS LETTERS, IEE STEVENAGE, GB, vol. 39, no. 25, 11 décembre 2003 (2003-12-11), pages 1848-1849, XP006024539 ISSN: 0013-5194
- DEMIGUEL S ET AL: "Partially depleated absorber waveguide photodiodes" LASERS AND ELECTRO-OPTICS SOCIETY, 2004. LEOS 2004. THE 17TH ANNUAL MEETING OF THE IEEE RIO GRANDE, PUERTO RICO NOV. 8-9, 2004, PISCATAWAY, NJ, USA,IEEE, vol. 1, 8 novembre 2004 (2004-11-08), pages 216-217, XP010748596 ISBN: 0-7803-8557-8
- ACHOUCHE M ET AL OPTICAL SOCIETY OF AMERICA / INSTITUTE OF ELECTRICAL AND ELECTRONICS ENGINEERS: "New all 2-inch manufacturable high performance evanescent coupled wavegulde photodlodes; with etched mirrors for 40 Gb/s optical receivers" OPTICAL FIBER COMMUNICATION CONFERENCE. (OFC). POSTCONFERENCE DIGEST. ATLANTA, GA, MARCH 23 - 28, 2003, TRENDS IN OPTICS AND PHOTONICS SERIES. (TOPS), WASHINGTON, DC : OSA, US, vol. TOPS. VOL. 86, 23 mars 2003 (2003-03-23), pages 341-342, XP010680111 ISBN: 1-55752-746-6
- GIRAUDET L ET AL: "High speed evanescently coupled <E1>PIN</E1> photodiodes for hybridisation on silicon platform optimised with genetic algorithm" ELECTRONICS LETTERS, IEE STEVENAGE, GB, vol. 37, no. 15, 19 juillet 2001 (2001-07-19), pages 973-975, XP006016974 ISSN: 0013-5194
- ACHOUCHE M ET AL: "Manufacturable 2.5 Gbit/s edge-coupled waveguide photodiode for optical hybrid-integrated modules" OPTICAL COMMUNICATION, 2001. ECOC '01. 27TH EUROPEAN CONFERENCE ON SEPT. 30 - OCT. 4, 2001, PISCATAWAY, NJ, USA,IEEE, vol. 4, 30 septembre 2001 (2001-09-30), pages 552-553, XP010582680 ISBN: 0-7803-6705-7
- MAGNIN V ET AL: "DESIGN, OPTIMIZATION, AND FABRICATION OF SIDE-ILLUMINATED P-I-N PHOTODETECTORS WITH HIGH RESPONSIVITY AND HIGH ALIGNMENT TOLERANCE FOR 1.3-AND 1.55-MUM WAVELENGTH USE" JOURNAL OF LIGHTWAVE TECHNOLOGY, IEEE SERVICE CENTER, NEW YORK, NY, US, vol. 20, no. 3, mars 2002 (2002-03), pages 477-488, XP001130096 ISSN: 0733-8724
- VINCENT MAGNIN ET AL.: "Design and Optimization of a 1.3/1.55 micrometer Wavelength Selective p-i-n Photodiode Based on Multimode Diluted Waveguide" IEEE PHOTONICS TECHNOLGY LETTERS, vol. 17, no. 2, 1 février 2005 (2005-02-01), pages 459-461, XP002372450
- VINCENT MAGNIN ET AL: "Design, Optimization, and Fabrication of Side-Illuminated p-i-n Photodetectors With High Responsivity and High Alignment Tolerance for 1.3- and 1.55-m Wavelength Use", JOURNAL OF LIGHTWAVE TECHNOLOGY, IEEE SERVICE CENTER, NEW YORK, NY, US, vol. 20, no. 3, 1 March 2002 (2002-03-01), XP011030146, ISSN: 0733-8724

## Description

Le domaine de l'invention est celui des dispositifs optoélectroniques de réception de signaux optiques numériques haut débit pour applications en télécommunications.

Très sommairement, une chaîne de transmission de signaux numériques optiques comporte trois ensembles principaux qui sont :
- Un ensemble optoélectronique de transduction des signaux électriques en signaux optiques ;
- Un dispositif à fibres optiques transmettant les signaux numériques optiques ;
- Un ensemble optoélectronique de transduction et de décodage des signaux optiques en signaux électriques.

L'invention porte sur ce dernier ensemble. De façon générale, il existe deux familles principales de dispositifs de ce type.

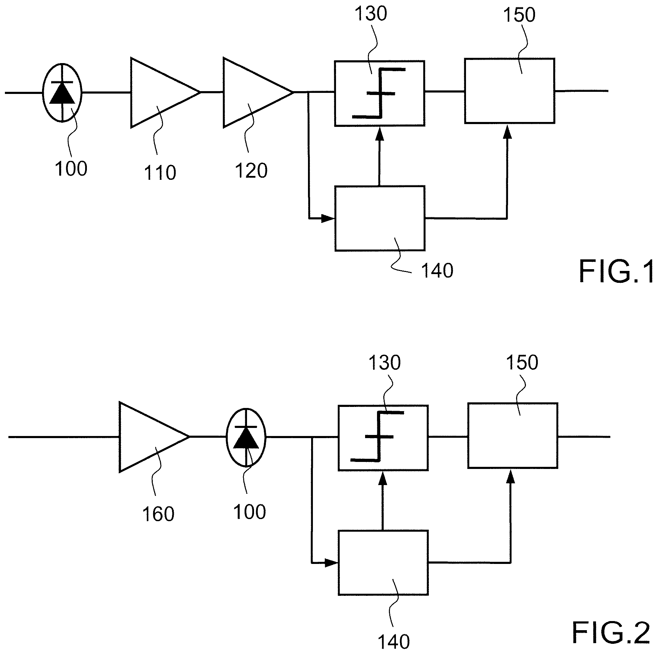

La figure 1 représente le schéma de principe d'un dispositif de premier type. Dans ce cas, le dispositif comporte une photodiode 100 qui transforme le signal optique en signal électrique. Cette diode est, par exemple, de type PIN, acronyme anglo-saxon signifiant Positive-Intrinsic-Negative ou APD, acronyme anglo-saxon signifiant Avalanche Photo Diode. Ce signal est ensuite pré-amplifié par un premier amplificateur 110, par exemple de type TIA, acronyme anglo-saxon de Trans Impedance Amplifier, puis par un second amplificateur noté 120. Le signal ainsi amplifié a alors une amplitude suffisante pour être analysé par un ensemble de circuits électroniques 130, 140 qui assurent à la fois la resynchronisation des signaux logiques et la validation de leur valeur binaire. Le signal numérique ainsi traité peut ensuite passer à travers un circuit de démultiplexage 150 lorsque le débit numérique est très important. On passe ainsi, par exemple, d'un signal numérique à la fréquence de 40 gigabits/seconde à 4 signaux numériques à la fréquence de 10 gigabits/seconde. Un des inconvénients de ce dispositif est qu'il ne peut fonctionner qu'avec des signaux optiques ayant un rapport signal/bruit suffisant. En effet, la chaîne d'amplification électronique qui comporte nécessairement un grand nombre de composants électroniques ajoute un bruit important, suffisant pour limiter les performances du système.

La figure 2 représente le schéma de principe du second type de dispositif. Dans ce cas, le signal optique est d'abord pré-amplifié dans un amplificateur optique 160 à semi-conducteur encore appelé SOA, acronyme anglo-saxon de Semiconductor Optical Amplifier ou par un amplificateur optique à fibre dopé à l'Erbium encore appelé EDFA, acronyme anglo-saxon de Erbium Doped Fiber Amplifier, puis le signal ainsi amplifié est converti au moyen d'une photodiode 100 en signal électrique. Les autres parties du dispositif sont identiques à celles du premier type et comportent un ensemble de circuits électroniques qui assurent à la fois la resynchronisation des signaux logiques et la validation de leur valeur binaire. On peut ainsi optimiser séparément le rapport signal/bruit, limité par le SOA et la rapidité, limitée par la bande passante de la photodiode. On obtient alors un bien meilleur rapport signal/bruit permettant de traiter des signaux plus faibles à des débits plus importants.

Généralement, les deux fonctions d'amplification optique et de conversion optique-électrique sont associées de façon hybride. Toutefois, des intégrations monolithiques commencent à voir le jour, ce qui permet de diminuer les coûts de réalisation, l'encombrement et d'augmenter la fiabilité. Cependant, cette intégration pose un certain nombre de problèmes techniques. En effet, la région active de l'amplificateur optique et de la photodiode sont nécessairement communes de façon à coupler sans pertes les faisceaux optiques passant de l'une à l'autre. Or, la zone active de l'amplificateur doit être mince de façon à assurer un fort rapport signal à bruit et une bonne linéarité. A l'inverse, pour obtenir une photodiode à haute sensibilité, la zone active doit être suffisamment épaisse. En effet, la sensibilité de la photodiode dépend du volume de sa zone active. Si cette zone active a une faible section, elle a donc nécessairement une longueur importante. Or, une zone active de forme allongée a une capacité importante qui limite la bande passante de la photodiode. Ainsi, dans un dispositif dans lequel la zone active du SOA et de la photodiode ont la même épaisseur, la longueur de la zone active de la photodiode a dû être portée à 80 microns de façon à conserver la sensibilité au détriment d'une bande passante inférieure à 40 gigaHertz. Pour obtenir la bande passante souhaitée, la longueur de la zone active n'aurait pas due dépasser 25 microns.

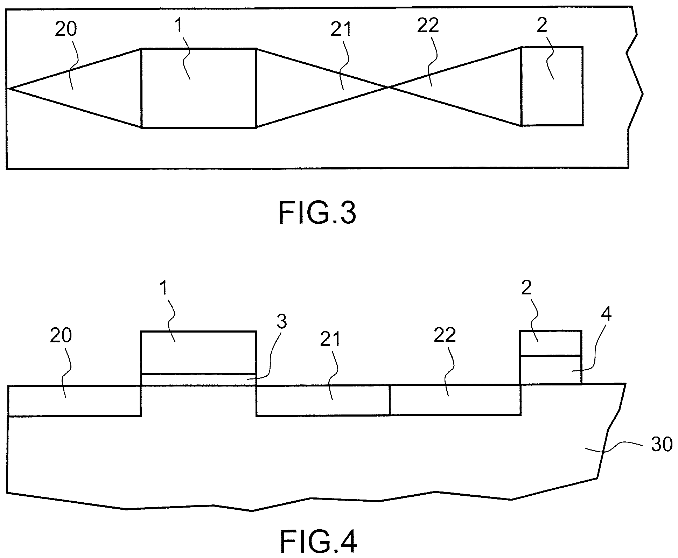

Pour optimiser l'ensemble du dispositif de conversion, il faut donc avoir une zone active de faible section dans la partie amplificatrice et de section plus importante dans la partie conversion. Pour réaliser cette fonction, on utilise généralement des adaptateurs de modes optiques encore appelés « taper » en terminologie anglo-saxonne. Les figures 3 et 4 représentent respectivement une vue de dessus et une vue latérale d'un dispositif de ce type. Il comprend successivement :
- Un premier « taper » 20 à section triangulaire ;
- Un amplificateur optique 1 de type SOA ;
- Un second jeu de « tapers » 21 et 22 ;
- Enfin, la photodiode de réception 2.

Sur ces figures, les électrodes permettant l'amplification optique et la conversion du signal optique en signal électrique ne sont pas représentées.

Comme on le voit sur la figure 4, la zone active 4 de la photodiode de réception 2 est plus épaisse que la zone active 3 de l'amplificateur optique 1 de façon à optimiser les performances du dispositif. Le second jeu de « tapers » 21 et 22 permet d'adapter parfaitement la taille des modes optiques de façon à conserver des rendements de transmission de l'amplificateur optique à la photodiode corrects.

Cependant, la réalisation technologique d'un tel ensemble est délicate. Il est bien entendu impossible de réaliser des tapers parfaits qui transmettent les modes optiques sans pertes. Le procédé de réalisation par gravure sèche ne permet pas de réaliser des surfaces parfaitement planes. Or, la rugosité résiduelle dégrade la propagation des faisceaux optiques. Les ensembles réalisés par cette méthode montre que le gain final du SOA, compte-tenu des pertes introduites par les tapers ne dépasse pas 10 dB.

L'objet de l'invention est de pallier les inconvénients issus de l'utilisation de « tapers » en remplaçant ces structures par une structure unique constituée d'un guide multimode dilué encore appelé en terminologie anglo-saxonne « diluted multimode waveguide ».
CAMPBELL J C ET AL, "New developments in high speed photodetectors", LASERS AND ELECTRO-OPTICS, 2004. (CLEO). CONFERENCE ON SAN FRANCISCO, CA, USA MAY 20-21, 2004, PISCATAWAY, NJ, USA,IEEE, (20040520), vol. 2, concerne une technologie de photodétecteur à grande vitesse avec intégration d'une photodiode avec un amplificateur optique semi-conducteur ou la combinaison de détecteurs dans un récepteur.
UMBACH A., "High-speed integrated photodetectors for 40 Gbit/s applications", PROCEEDINGS OF THE SPIE, SPIE, BELLINGHAM, VA, US, (2003), vol. 5246, no. 1, ISSN 0277-786X, pages 434 - 442, décrit des photodétecteurs photoniques intégrés construits en combinant des dispositifs à onde guidée, optoélectroniques et à micro-ondes pour offrir un rendement de conversion élevé, un fonctionnement à vitesse extrêmement élevée et une linéarité de puissance élevée jusqu'à 20 mW de puissance optique.
MAGNIN V ET AL, "DESIGN, OPTIMIZATION, AND FABRICATION OF SIDE-ILLUMINATED P-I-N PHOTODETECTORS WITH HIGH RESPONSIVITY AND HIGH ALIGNMENT TOLERANCE FOR 1.3-AND 1.55-MUM WAVELENGTH USE", JOURNAL OF LIGHTWAVE TECHNOLOGY, IEEE SERVICE CENTER, NEW YORK, NY, US, (200203), vol. 20, no. 3, décrit la conception, l'optimisation et la fabrication de photodétecteurs p-i-n éclairés latéralement, développés sur substrat InP, adaptés à l'intégration hybride de surface dans des modules à faible coût.

Plus précisément, l'invention a pour objet un dispositif opto-électronique de photo-réception d'un signal optique après la revendication 1 et comprenant entre autres au moins une structure comportant une section d'amplification optique comprenant une première zone active et une section de photo-réception comprenant une seconde zone active, caractérisé en ce que la dite structure comporte un guide multimode dilué commun aux deux sections, la première zone active et la seconde zone étant disposées de façon à assurer un couplage par ondes évanescentes avec ledit guide multimode dilué.

La première zone active a une épaisseur inférieure à celle de la seconde zone active et la section d'amplification optique est de type SOA.

Plus précisément, le guide multimode dilué comporte au moins un empilement de 2N couches minces planes et parallèles entre elles, régulièrement alternées indicées notées Cᵢ, les couches étant préférentiellement en matériau de type quaternaire InGaAsP. Plus précisément, les couches dont l'indice est pair, sont en InP ; les couches dont l'indice est impair étant en InGaAsP. Préférentiellement, le nombre N vaut 5, les couches en InGaAsP ont toutes une épaisseur valant environ 0,16 micron et les couches en InP ont une épaisseur comprise entre 0,36 micron et 0,66 micron.

De plus, le guide multimode dilué peut comporter une couche d'accord d'indice située en partie sous les zones actives, ladite couche étant en InGaAsP.

Avantageusement, la première zone active de la section d'amplification comprend une couche de GaInAs qui peut être en tension, par exemple, à -0,32% et la seconde zone active de la section de photoréception comprend une couche de GaInAs.

De plus, la structure du SOA comporte au moins deux structures à confinement séparé dite SCH identiques situées au-dessus et en dessous de la première zone active. Chaque structure à confinement séparé peut être en InGaAsP et a une épaisseur de 30 nanomètres.

L'invention sera mieux comprise et d'autres avantages apparaîtront à la lecture de la description qui va suivre donnée à titre non limitatif et grâce aux figures annexées parmi lesquelles :
- La figure 1 représente le schéma de principe d'un premier ensemble optoélectronique de transduction et de décodage des signaux optiques en signaux électriques ;
- La figure 2 représente le schéma de principe d'un second ensemble optoélectronique de transduction et de décodage des signaux optiques en signaux électriques ;
- Les figures 3 et 4 représentent une vue de dessus et une vue de côté d'un ensemble opto-électronique de photo-réception selon l'art antérieur ;
- La figure 5 représente une vue en coupe dans un plan perpendiculaire aux couches d'un guide multimode dilué ;
- La figure 6 représente la propagation des modes optiques dans un guide multimode dilué ;
- Les figures 7 et 8 représentent une vue de dessus et une vue de côté d'un ensemble opto-électronique de photo-réception selon l'invention ;

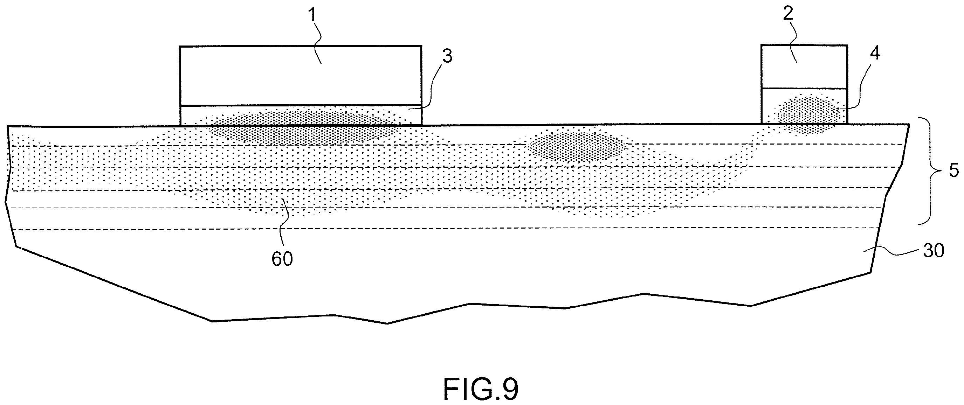

- La figure 9 représente la propagation des modes optiques dans un ensemble opto-électronique de photo-réception selon l'invention.

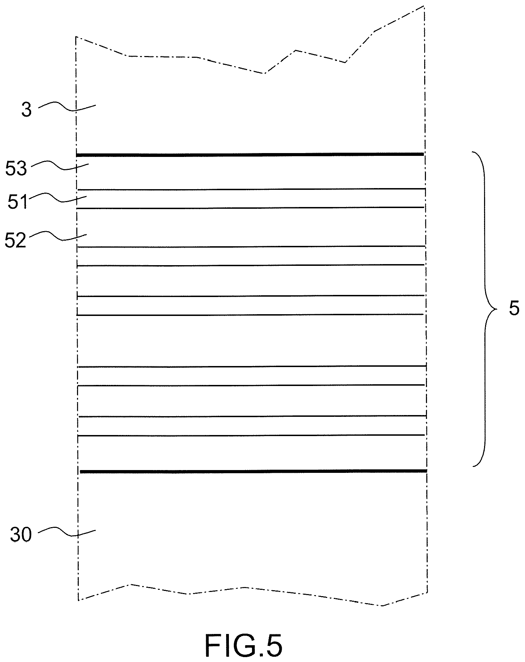

Un guide multimode 5 dilué comprend un empilement de couches minces 51, 52 planes et parallèles entre elles comme représenté en figure 5. Généralement, le guide multimode 5 dilué comporte au moins un empilement de 2N couches régulièrement alternées indicées notées Cᵢ reposant sur un substrat 30. Son épaisseur est de quelques microns.

A titre d'exemple, les couches dont l'indice est pair peuvent être en InP, les couches dont l'indice est impair étant en InGaAsP, l'empilement comprenant 10 couches. Les couches en InGaAsP ont toutes une épaisseur valant environ 0,16 micron et les couches en InP ont une épaisseur comprise entre 0,36 micron et 0,66 micron.

Le guide multimode dilué peut comporter une couche 53 d'accord d'indice située en partie sous les zones actives. Cette couche peut être en InGaAsP.

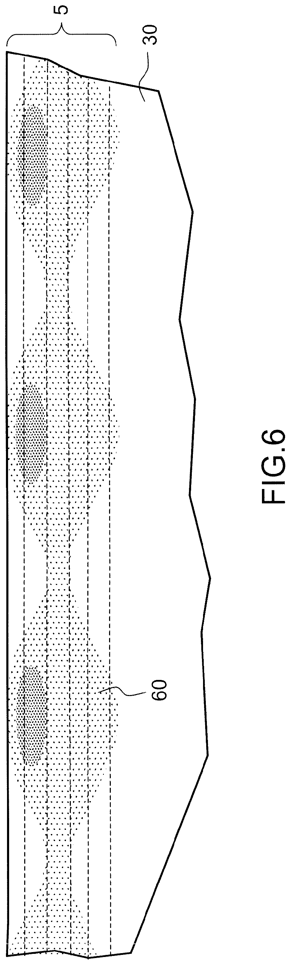

La propagation de la lumière dans ce type de guide comprenant de nombreuses couches de dimensions inférieures à celle de la longueur d'onde de la lumière ne peut pas se calculer aisément. Aussi, on utilise des logiciels de simulation de type BPM, acronyme anglo-saxon pour « Beam Propagation Method », les simulations peuvent être faites soit en 2D, soit en 3D. Ces logiciels permettent de simuler la propagation de la lumière dans un guide multimode dilué. Les simulations montrent que les battements intermodaux font que la propagation de la lumière est un phénomène périodique, l'amplitude de la période faisant quelques dizaines de microns. La figure 6 montre de façon très schématique les variations d'amplitude de la lumière dans un plan perpendiculaire au plan moyen des couches et parallèle à la direction de propagation. La densité d'énergie lumineuse 60 à l'intérieur du guide est représentée par une répartition de points plus ou moins dense sur la figure 6. Une répartition judicieuse des couches permet de concentrer périodiquement l'énergie lumineuse près de l'interface comme indiqué sur la figure 6.

Ainsi, en disposant une zone active sur ces zones de concentration d'énergie, il est possible de coupler l'onde évanescente dans la zone active avec un haut rendement de couplage.

On utilise cette propriété pour réaliser un dispositif opto-électronique de photo-réception selon l'invention.

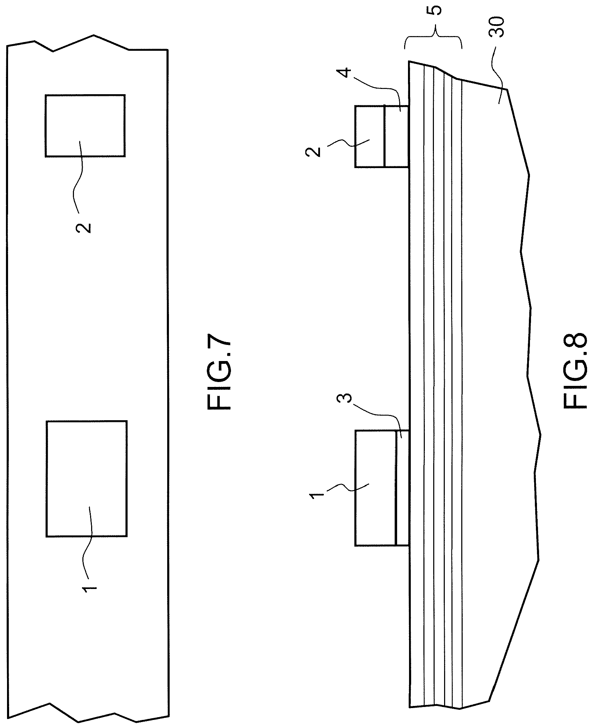

Les figures 7 et 8 représentent respectivement une vue de dessus et une vue de côté d'un dispositif selon l'invention. Il comprend successivement :
- Un amplificateur optique 1 de type SOA ;
- une photodiode de réception 2;
- Un guide multimode dilué 5 reposant sur un substrat 30.

L'amplificateur optique 1 comprend essentiellement une zone active 3 de faible épaisseur. La photodiode 2 comprend également une zone active 4 d'épaisseur plus importante. Les épaisseurs des zones actives sont ainsi optimisées séparément. On obtient alors dans la section d'amplification optique une bonne linéarité, un gain important, un bruit faible et une bonne indépendance vis-à-vis de la polarisation de la lumière. Et on obtient dans la section de photo-réception une bonne sensibilité, une bande passante élevée et une puissance optique à saturation optimisée.

Le guide multimode dilué 5 est commun aux deux sections. L'emplacement des deux zones actives 3 et 4 est choisi de façon à optimiser le couplage des ondes évanescentes dans les zones actives. Comme il a été dit, il est préférable d'utiliser des logiciels de simulation de type BPM pour réaliser cette optimisation. La périodicité de la propagation de la lumière dans le guide autorise une certaine liberté dans le choix de l'emplacement de l'amplificateur optique et de la photodiode. En effet, un changement d'emplacement égal à une période de propagation ne modifie pas sensiblement les rendements de couplage.

A titre d'exemple, un dispositif opto-électronique de photo-réception selon l'invention comporte un guide multimode dilué dont la période de propagation des modes vaut environ 50 microns, une section d'amplification optique d'environ 100 microns de long et une section de photo-réception d'environ 30 microns de long, les deux sections étant séparées par une distance de 60 microns, ces différentes valeurs étant choisies de façon à assurer un couplage optimal des ondes évanescentes circulant dans le guide à la fois avec la section d'amplification et la section de photo-réception. La photodiode est de type PIN, optimisée pour fonctionner avec une bande passante de 40 gigabits par seconde. Elle possède une zone active dont l'épaisseur fait 0,4 micron. On obtient ainsi une efficacité quantique de conversion de 80 %. Dans ce cas, la tolérance verticale de positionnement du guide multimode dilué destiné à être utilisé avec une fibre optique à extrémité lentillée est de 1 micron pour obtenir une perte de couplage inférieure à 1 dB.

## Revendications

1. Dispositif opto-électronique de photo-réception d'un signal optique comprenant au moins une structure comportant :
• une section d'amplification optique (1) comprenant une première zone active (3) et,
• une section de photo-réception (2) comprenant une seconde zone active (4),
la dite structure comportant en outre un guide multimode dilué (5) commun aux deux sections, les sections d'amplification et de photo-réception étant disjointes, une face de la zone active de la section d'amplification et une face de la zone active de la section de photo-réception étant en contact direct avec ledit guide multimode dilué,
**caractérisé en ce que** la première zone active a une épaisseur inférieure à celle de la seconde zone active, la première zone active et la seconde zone active étant disposées de façon à assurer un couplage par ondes évanescentes avec ledit guide multimode dilué de telle façon qu'en réponse à une propagation du signal optique, le guide multimode dilué est adapté à concentrer périodiquement l'énergie lumineuse près de la première zone active (3), et de la seconde zone active (4) ladite périodicité étant le résultat des battements intermodaux de modes d'onde propageant dans le guide multimode dilué.

2. Dispositif selon la revendication 1, **caractérisé en ce que** la section d'amplification optique est de type SOA.

3. Dispositif selon l'une des revendications précédentes, **caractérisé en ce que** le guide multimode dilué comporte au moins un empilement de 2N couches (51, 52) minces planes et parallèles entre elles, régulièrement alternées indicées notées Cᵢ, les couches dont l'indice est pair étant en InP, les couches dont l'indice est impair étant en InGaAsP.

4. Dispositif selon la revendication 3, **caractérisé en ce que** le nombre N vaut 5.

5. Dispositif selon l'une des revendications 3 ou 4, **caractérisé en ce que** les couches en InGaAsP ont toutes une épaisseur valant environ 0,16 micron.

6. Dispositif selon l'une des revendications 3 à 5, **caractérisé en ce que** les couches en InP ont une épaisseur comprise entre 0,36 micron et 0,66 micron.

7. Dispositif selon l'une des revendications précédentes, **caractérisé en ce que** le guide multimode dilué comporte une couche d'accord d'indice (53) située en partie sous les zones actives.

8. Dispositif selon la revendication 7, **caractérisé en ce que** ladite couche est en InGaAsP.

9. Dispositif selon l'une des revendications précédentes, **caractérisé en ce que** la première zone active de la section d'amplification comprend une couche de GaInAs.

10. Dispositif selon l'une des revendications précédentes, **caractérisé en ce que** la seconde zone active de la section de photoréception comprend une couche de GaInAs.

## Patentansprüche

1. Optoelektronische Vorrichtung für die Lichterfassung eines optischen Signals, umfassend mindestens eine Struktur, umfassend:
• einen optischen Verstärkerabschnitt (1), umfassend einen ersten aktiven Bereich (3) und
• einen Lichterfassungsabschnitt (2), umfassend einen zweiten aktiven Bereich (4),
wobei die Struktur außerdem einen verdünnten Multimode-Leiter (5) umfasst, der beiden Abschnitten gemeinsam ist, wobei die Verstärker- und Lichterfassungsabschnitte getrennt sind, wobei eine Fläche des aktiven Bereichs des Verstärkerabschnitts und eine Fläche des aktiven Bereichs des Lichterfassungsabschnitts in direktem Kontakt mit dem verdünnten Multimode-Leiter sind,
**dadurch gekennzeichnet, dass** der erste aktive Bereich eine geringere Dicke als der zweite aktive Bereich aufweist, wobei der erste aktive Bereich und der zweite aktive Bereich so angeordnet sind, dass eine Kopplung durch evaneszente Wellen mit dem verdünnten Multimode-Leiter dahingehend gewährleistet ist, dass als Reaktion auf eine Ausbreitung des optischen Signals der verdünnte Multimode-Leiter dafür ausgelegt ist, die Lichtenergie nahe des ersten aktiven Bereichs (3) und des zweiten aktiven Bereichs (4) regelmäßig zu konzentrieren, wobei die Regelmäßigkeit das Ergebnis von intermodalen Taktschlägen der Arten von Wellen ist, die sich in dem verdünnten Multimode-Leiter ausbreiten.

2. Vorrichtung nach Anspruch 1, **dadurch gekennzeichnet, dass** der optische Verstärkungsabschnitt vom Typ SOA (Semiconductor Optical Amplifier - Optischer Halbleiterverstärker) ist.

3. Vorrichtung nach einem der vorangegangenen Ansprüche, **dadurch gekennzeichnet, dass** der verdünnte Multimode-Leiter mindestens einen Stapel aus 2N Dünnschichten (51, 52) umfasst, welche eben und zueinander parallel sind und gleichmäßig abwechselnd mit Cᵢ bezeichnete Indizes umfassen, wobei die Schichten, deren Index geradzahlig ist, aus InP bestehen, während die Schichten, deren Index ungerade ist, aus InGaAsP bestehen.

4. Vorrichtung nach Anspruch 3, **dadurch gekennzeichnet, dass** die Zahl N 5 beträgt.

5. Vorrichtung nach einem der Ansprüche 3 oder 4, **dadurch gekennzeichnet, dass** die Schichten aus InGaAsP alle eine Dicke aufweisen, die ungefähr 0,16 Mikron entspricht.

6. Vorrichtung nach einem der Ansprüche 3 bis 5, **dadurch gekennzeichnet, dass** die Schichten aus InP eine Dicke aufweisen, die zwischen 0,36 Mikron und 0,66 Mikron beträgt.

7. Vorrichtung nach einem der vorangegangenen Ansprüche, **dadurch gekennzeichnet, dass** der verdünnte Multimode-Leiter eine Schicht für das Anpassen des Index (53) enthält, die sich teilweise unter den aktiven Bereichen befindet.

8. Vorrichtung nach Anspruch 7, **dadurch gekennzeichnet, dass** die Schicht aus InGaAsP besteht.

9. Vorrichtung nach einem der vorangegangenen Ansprüche, **dadurch gekennzeichnet, dass** der erste aktive Bereich des optischen Verstärkungsabschnitts eine Schicht aus GalnAs umfasst.

10. Vorrichtung nach einem der vorangegangenen Ansprüche, **dadurch gekennzeichnet, dass** der zweite aktive Bereich des Lichterfassungsabschnitts eine Schicht aus GalnAs umfasst.

## Claims

1. Optoelectronic apparatus for the photoreception of an optical signal with at least one structure including:
• an optical amplifier section (1) including a first active zone (3), and
• a photoreception section (2) including a second active zone (4),
wherein said structure further includes a diluted multimode guide (5) common to the two sections, while the optical amplifier section and the photoreception section are separated, wherein a face of the active zone of the amplifier section and a face of the active zone of the photoreception section are in direct contact with said diluted multimode guide,
**characterized in that** the first active zone is thinner than the second active zone, wherein the first active zone and the second active zone are arranged so as to provide a coupling of evanescent waves with said diluted multimode guide, so that, in response to a propagation of the optical signal, the diluted multimode guide is designed to periodically focus the photonic energy close to the first active zone (3) and to the second zone (4), wherein said periodicity is the result of the intermodal beats of the wave modes through the diluted multimode guide.

2. Apparatus according to claim 1, **characterized in that** the optical amplifier section is a SOA optical amplifier.

3. Apparatus according to any of the preceding claims, **characterized in that** the diluted multimode guide includes at least 2N stacked, flat, parallel, regularly alternated thin layers (51, 52), noted Cᵢ, wherein layers with an even subscript index are made of InP, while layers with an odd subscript index are made of InGaAsP.

4. Apparatus according to claim 3, **characterized in that** N = 5.

5. Apparatus according to any of the claims 3 or 4, **characterized in that** all InGaAsP layers are ca. 0.16 µm thick.

6. Apparatus according to any of the claims 3 to 5, **characterized in that** all InP layers are between 0.36 and 0.66 µm thick.

7. Apparatus according to any of the preceding claims, **characterized in that** the diluted multimode guide includes an index-matching layer (53) partly located under the active zones.

8. Apparatus according to claim 7, **characterized in that** said layer is made of InGaAsP.

9. Apparatus according to any of the preceding claims, **characterized in that** said first active zone of the amplifier section includes a GalnAs layer.

10. Apparatus according to any of the preceding claims, **characterized in that** said second active zone of the photoreception section includes a GalnAs layer.
